## Europäisches Patentamt
## European Patent Office
## Office européen des brevets

(11) Publication number: **0 030 130**
**B1**

# EUROPEAN PATENT SPECIFICATION

(45) Date of publication of patent specification: **14.09.83**

(51) Int. Cl.³: **H 03 K 3/354**

(21) Application number: **80304265.4**

(22) Date of filing: **27.11.80**

(54) An oscillator and an EPROM including such an oscillator.

(30) Priority: **29.11.79 JP 154579/79**

(43) Date of publication of application:
**10.06.81 Bulletin 81/23**

(45) Publication of the grant of the patent:
**14.09.83 Bulletin 83/37**

(84) Designated Contracting States:
**DE FR GB NL**

(56) References cited:
**FR - A - 2 118 357**
**FR - A - 2 290 089**
**US - A - 4 115 710**
**US - A - 4 122 361**

**IBM TECHNICAL DISCLOSURE BULLETIN,**
**vol. 16 no. 1, June 1973, pages 317-318 New**
**York, U.S.A. H. C. CHANG et al.: "Integrated**
**delay circuit/noise rejection circuit"**

(73) Proprietor: **FUJITSU LIMITED**
**1015, Kamikodanaka Nakahara-ku**
**Kawasaki-shi Kanagawa 211 (JP)**

(72) Inventor: **Higuchi, Mitsuo**
**5-13 Yutenji 2-chome Meguro-ku**
**Tokyo 153 (JP)**

(74) Representative: **Rackham, Stephen Neil et al,**
**GILL JENNINGS & EVERY 53-64 Chancery Lane**
**London WC2A 1HN (GB)**

Courier Press, Leamington Spa, England

## An oscillator and an EPROM including such an oscillator

This invention relates to an oscillator circuit for providing an oscillation output having a duty ratio greater than 50%, and more particularly to an oscillator circuit for controlling, for example, a bootstrap circuit included in an EPROM (Erasable Programmable Read Only Memory) which is erasable by means of ultraviolet light.

In general, a mounting package of an EPROM which is erasable by ultraviolet light is provided with a window to allow ultraviolet light to impinge on the EPROM. To erase the stored contents, ultraviolet light is shone on the EPROM through the window. However, during writing of data in the EPROM, external light may also penetrate through the window and impinge on the EPROM, with the result that light incident on junction capacitances in a bootstrap circuit included in the EPROM may increase charge leakage from charges stored in the junction capacitance, so that the write-in voltage is lowered to such an extent that writing in data is prevented. To avoid this lowering of the voltage, an oscillator circuit is usually included in the EPROM, so that the junction capacitances are repeatedly charged up during writing in of data.

In a conventional oscillator circuit used in an EPROM, the output signal has a duty ratio substantially equal to 50%. Therefore, within one complete period of the output, the time of high potential is substantially equal to the time of a low potential. When the output of this oscillator circuit is connected to the input of the bootstrap circuit in the EPROM, the high potential interval and the low potential interval usually correspond to a programmable interval and a reset interval, respectively, as hereinafter described in detail. Accordingly, by the use of the conventional oscillator circuit, the programmable interval, or in other words, the write-in interval, is substantially equal to the reset interval, or, the interval for charging junction capacitances included in the bootstrap circuit.

However, to increase the write-in efficiency, the write-in interval must be as long as possible and the reset interval must be as short as possible. To meet this requirement, the input of the bootstrap circuit preferably receives an oscillating signal having a duty ratio different from 50%. To obtain such a signal having a duty ratio different from 50%, a combination of frequency dividers is connected to the output of the conventional oscillator circuit. However, such prior art technique has disadvantages in that a number of frequency dividers are required, causing the cost to be increased as well as necessitating the troublesome task of making frequency dividers for obtaining the desired duty ratio.

According to one aspect of the present invention, an oscillator circuit for providing an oscillating output having a greater than 50% duty ratio including a delay circuit having its output positively fed back to its input, the delay circuit comprising a plurality of inverters and capacitive resistive time constant circuits connected alternately in series, the capacitive resistive time constant circuits each comprising a depletion type MOS transistor and capacitance is characterised in that the gates of the MOS transistors are connected to their drain or source alternately so that the delay times of all the capacitive resistive time constant circuits are added together to provide a duty ratio of the oscillator greater than 50%.

Another aspect of this invention is an EPROM having a bootstrap circuit including capacitance and an oscillator for controlling the charging of the capacitance during the writing of information into the EPROM where the oscillator circuit is in accordance with the one aspect of this invention.

A particular example of an oscillator circuit and an EPROM including an oscillator circuit in accordance with this invention will now be described and contrasted with the prior art with reference to the accompanying drawings; in which:—

Figure 1 is a circuit diagram of a conventional oscillator circuit;

Figure 2 is a graph illustrating the output waveform of the prior art circuit;

Figure 3 is a circuit diagram of an oscillator circuit in accordance with the present invention;

Figure 4 is a graph illustrating the output waveform of the oscillator circuit in accordance with the present invention;

Figure 5 is a circuit diagram of a part of a write-in circuit in an EPROM which is connected to the circuit shown in Figure 3.

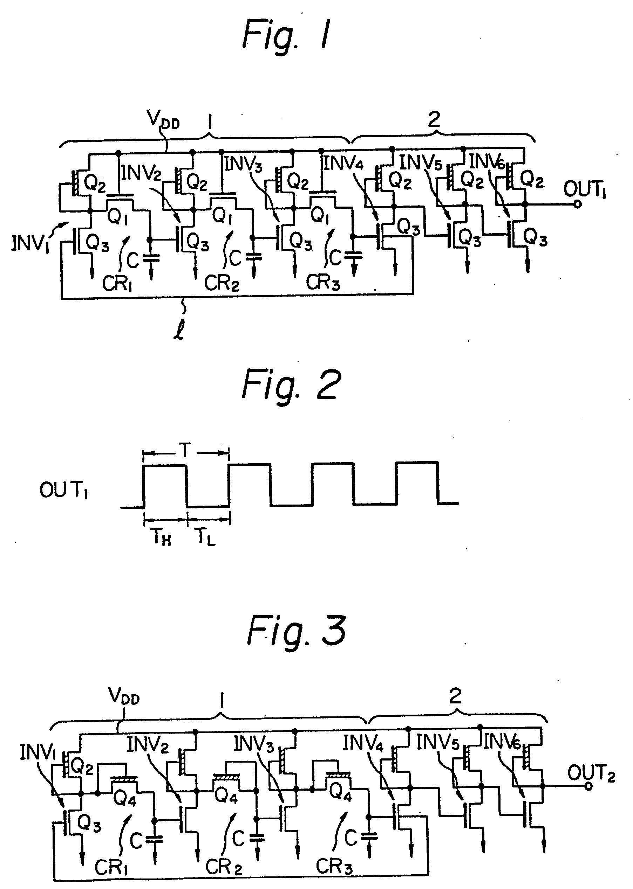

Before describing the preferred embodiment, a conventional oscillator circuit will first be described, with reference to Figures 1 and 2. Figure 1 is a circuit diagram of an example of a conventional oscillator circuit. Figure 2 is a diagram of an output waveform at an output terminal of the circuit of Figure 1. With reference to Figure 1, the oscillator circuit is comprised of a delay circuit 1 and a waveform shaping circuit 2 connected to the output of the delay circuit 1. The delay circuit 1 includes three inverters $INV_1$ through $INV_3$ and three time constant circuits $CR_1$ through $CR_3$. Each of the three inverters $INV_1$ through $INV_3$ is comprised of a depletion type load MOS transistor $Q_2$ in which the gate is connected to the source, and an enhancement type driving transistor $Q_3$. The output of each inverter is connected to the CR time constant circuit $CR_1$, $CR_2$ or $CR_3$. Each of the CR time constant circuits $CR_1$ through $CR_3$ is comprised of an enhancement type MOS transistor $Q_1$ used as a resistance and a capacitance $C$ connected to the transistor $Q_1$. The output of the final stage CR time constant circuit $CR_3$ is fed back to the gate of the tran-

sistor $Q_3$ in the first stage inverter $INV_1$. The wave-form shaping circuit 2 is comprised of three inverters $INV_4$ through $INV_6$. Each of the inverters $INV_4$ through $INV_6$ is comprised of a depletion type load transistor $Q_2$ and an enhancement type driving transistor $Q_3$. The first stage inverter $INV_4$ receives the output of the delay circuit 1. The final stage inverter $INV_6$ provides at the output terminal $OUT_1$ an oscillation output which has been shaped and the phase of which has been inverted from the phase of the input signal.

In the operation of the delay circuit 1, when the first stage inverter $INV_1$ outputs a high potential, the capacitor C in the CR time constant circuit $CR_1$ connected to the output of the inverter $INV_1$ is charged through the transistor $Q_1$. In contrast with this, when the inverter $INV_1$ outputs a low potential, the same capacitance C is discharged through the same transistor $Q_1$. The other CR time constant circuits $CR_2$ and $CR_3$ operate in the same way as the circuit $CR_1$. By these charging and discharging operations, a signal applied to the input of the first inverter $INV_1$ is delayed by a predetermined time which is determined by the values of the resistances of the transistors $Q_1$ and the capacitances C. Also, since there are three inverters $INV_1$ through $INV_3$, i.e. an odd number of inverters, positive feedback is effected from the output of the final stage CR time constant circuit to the first stage inverter $INV_1$ through a conduction line l. Thus, an oscillation output having a predetermined period or a predetermined frequency is obtained at the output terminal $OUT_1$. The wave-form shaping circuit 2 only shapes the gradually changing wave form outputted from the delay circuit 1 to obtain a rapidly changing wave form, and, if required, inverts the phase of the input signal. The phase inversion may be required depending on the construction of a bootstrap circuit which is to be connected to the output terminal $OUT_1$. Therefore, the wave-form shaping circuit 2 does not directly relate to the operation of oscillation.

It should be noted that, according to the conventional oscillator circuit as illustrated in Fig. 1, the time constant of the CR time constant circuit is the same in both cases when the capacitance C is charged and when the capacitance C is discharged. That is, the transistor $Q_1$ functions as pure resistance and the gate of the transistor $Q_1$ is connected to a power supply $V_{DD}$. Therefore, the time constant during charging is substantially the same as the time constant during discharging in each of the CR time constant circuits $CR_1$ through $CR_3$. As a result, the oscillation output obtained at the output terminal has a duty ratio substantially equal to 50%, as illustrated in Fig. 2. In Fig. 2, within one period T of the oscillation frequency, the interval $T_H$ of the high potential is equal to the interval $T_L$ of the low potential. As already described hereinbefore, such an oscillation signal having a duty ratio of 50% is not suitable for, for example, a programming circuit in an EPROM.

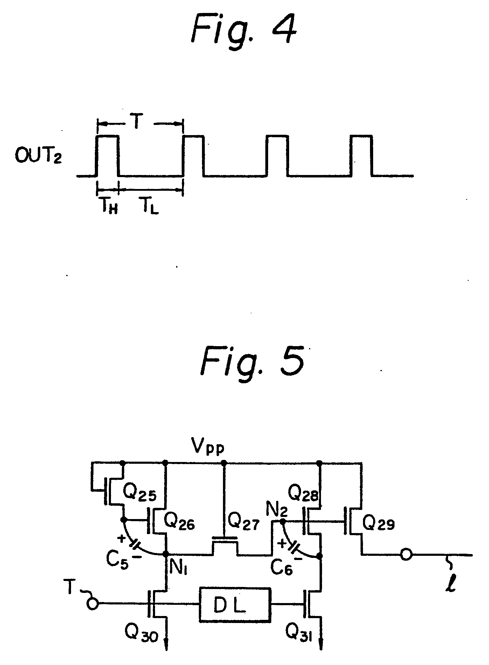

An embodiment of the present invention will now be described in detail with reference to Figs. 3 and 4. Fig. 3 is a circuit diagram illustrating an oscillator circuit according to one embodiment of the present invention, in which like reference characters designate the same or similar parts of the circuit of Fig. 1. The main difference between the circuit of Fig. 1 and the circuit of Fig. 3 resides in that, in place of the enhancement type MOS transistor $Q_1$ as a resistor in each of the CR time constant circuits $CR_1$ through $CR_3$ in the circuit of Fig. 1, a depletion type MOS transistor $Q_4$ is employed as a resistor in each of the CR time constant circuits $CR_1$ through $CR_3$ in the circuit of Fig. 3. Also, in place of connecting the gate of the enhancement type MOS transistor $Q_1$ to the power supply $V_{DD}$ in Fig. 1, the gate of the depletion type MOS transistor $Q_4$ is connected to its drain or its source in Fig. 3. That is, in the CR time constant circuit $CR_1$ as an example, the gate of the transistor $Q_4$ is connected to its drain which is connected to the output of the first stage inverter $INV_1$. The capacitor C in each CR time constant circuit is constructed by a junction capacitance between the drain or the source and the semiconductor substrate of a depletion type MOS transistor $Q_4$, or by a MOS capacitance. By this construction, the equivalent resistance of the transistor $Q_4$, when its gate voltage varies from a low voltage L to a high voltage H, or in other words, when the output of the first stage inverter $INV_1$ is turned from a low potential L to a high potential H, is smaller than that when its gate voltage varies from H to L. Therefore, the time constant of the CR time constant circuit $CR_1$, during which the capacitance C is being charged, that is, when the voltage at the gate of the transistor $Q_4$ is being increased from L to H, is smaller than the time constant during which the capacitance C is being discharged, that is, when the voltage at the gate of the transistor $Q_4$ is being decreased from H to L. As a result, the transition time required to change from L to H the output voltage of the CR time constant circuit $CR_1$, that is, the voltage across the capacitance C, is smaller than the transition time required to change from H to L the output voltage of the CR time constant circuit $CR_1$. Similarly, in the other CR time constant circuits $CR_2$ and $CR_3$, the above mentioned different transition times can be obtained with respect to the changes of the output voltages of these circuits.

It should be noted that, in the second stage time constant circuit $CR_2$, the gate of the transistor $Q_4$ is not connected to the input of this time constant circuit $CR_2$, that is, to the drain of the transistor $Q_4$, but is connected to the output of the circuit $CR_2$, that is, to the source of the transistor $Q_4$. In such a way, the gate of the transistor $Q_4$ is connected alternately to the drain or to the source in the neighbouring CR time constant circuits, respectively. By this construction, the delay times of all the time constant circuits are added. In this embodiment, since three time-constant circuits $CR_1$ through $CR_3$ are provided, the total delay time is three times the delay time obtained by one CR time constant circuit. Thus, an oscillation frequency having a duty ratio sufficiently different from 50% can be obtained at the output terminal $OUT_2$ of the oscillation circuit of Fig. 3.

If all of the gates of the transistors $Q_4$ were connected to the same side, that is, to the input side or to the output side, of their time constant circuits, respectively, the delay times would be cancelled by each other, because the neighbouring two inverters operate inversely to each other. That is, if there are an even number of time constant circuits, the delay times would be completely cancelled, and, if there are an odd number of time constant circuits, only one delay time obtained by one CR time constant circuit is left and the other delay times are cancelled. Therefore, if all of the gates of the transistors $Q_4$ were connected to the same sides, the duty ratio of the output frequency would not be sufficiently different from 50%.

Fig. 4 is a diagram illustrating an output wave form at an output terminal of the circuit of Fig. 3. As illustrated in Fig. 4, the interval $T_H$ of the high potential is shorter than the interval $T_L$ of the low potential. Therefore, the duty ratio

$$[T_H/(T_H+T_L)] \times 100$$

is different from 50%. It will be apparent that the high potential interval $T_H$ can be made longer than the low potential interval $T_L$ by taking out the oscillation output from the output of the second inverter $INV_5$ in the wave-form shaping circuit 2. Whether the high potential interval $T_H$ should be shorter or longer than the low potential interval $T_L$ is dependent on the construction of the bootstrap which is to be controlled by the oscillation circuit of Fig. 3.

Fig. 5 is a circuit diagram illustrating a part of a write-in circuit in an EPROM which is to be connected to the output of the circuit of Fig. 3. In Fig. 5, I represents a conduction line, or a bit line, connected to memory cells in the PROM; $V_{PP}$ represents a high power supply voltage of, for example, 25 V for writing data in the PROM; $Q_{29}$ represents a transistor for controlling the power supply voltage $V_{PP}$ to connect to or disconnect from the conduction line I, the gate of the transistor $Q_{29}$ being controlled by two stages of the bootstrap circuits; $C_5$ and $C_6$ represent the capacitances of the bootstrap circuits; $Q_{25}$ through $Q_{28}$ represent the transistors of the bootstrap circuit; $Q_{30}$ and $Q_{31}$ represent transistors for controlling the bootstrap circuit; DL represents a delay circuit, and; T represents a control terminal for receiving the oscillation frequency from the output terminal $OUT_2$ of the circuit of Fig. 3.

In the operation of the circuit of Fig. 5, when the input voltage at the control terminal T becomes high H, the transistor $Q_{30}$ turns on so that the capacitor $C_5$ is charged by the power supply voltage $V_{PP}$ through the transistor $Q_{25}$ to have a polarity as illustrated. Also, after a time delay determined by the delay circuit DL, the transistor $Q_{31}$ is turned on so that the capacitor $C_6$ is discharged through transistors $Q_{27}$ and $Q_{30}$ to the ground potential. The transistor $Q_{29}$ receives at its gate the voltage across the capacitor $C_6$. The voltage across the capacitor $C_6$ when the transistors $Q_{30}$ and $Q_{31}$ are on is not sufficient to turn on the transistor $Q_{29}$. Therefore, when the voltage at the control terminal T is high H, the conduction line I is separated from the power supply voltage $V_{PP}$.

When the input voltage at the control terminal T becomes low L, the transistor $Q_{30}$ turns off, so that the potential at the node $N_1$ increases. Since the potential at the gate of the transistor $Q_{26}$ is higher than the potential at the node $N_1$ by the voltage across the capacitance $C_5$, the transistor $Q_{26}$ is driven to be completely turned on. Thus, the potential at the node $N_1$ increases to a voltage nearly equal to the power supply voltage $V_{PP}$ without being decreased by the threshold voltage $V_{TH}$ of the transistor $Q_{26}$. The voltage at the node $N_1$ is applied through the transistor $Q_{27}$ to the capacitance $C_6$ to charge it, as well as to the gate of the transistor $Q_{29}$ to turn it on. Thus, the potential of the conduction line I begins to increase. After the time delay of the delay circuit DL, the gate of the transistor $Q_{31}$ receives the low voltage L so that the transistor $Q_{31}$ turns off. Then, the potential at the node $N_2$ increases. The potential at the gate of the transistor $Q_{28}$ then becomes higher than the potential at the node $N_2$ by the voltage across the capacitance $C_6$, resulting in the further increase of the potential at the node $N_2$ to a value nearly equal to the power supply voltage $V_{PP}$. Also, the potential at the gates of the transistors $Q_{28}$ and $Q_{29}$ becomes higher than the potential at the node $N_2$. Then, the transistor $Q_{27}$ is turned off. Thus, the potential of the conduction line I increases to the power supply voltage $V_{PP}$. This operation, as described with reference to Fig. 5, is well known as a bootstrap operation.

When the potential of the conduction line I is high H, or, in other words, when the potential at the control terminal T which receives control signals from the output terminal $OUT_2$ of the circuit of Fig. 3 is low L, data are written in the PROM. That is, when the potential of the conduction line I is high H, each cell in the PROM receives between its source and drain a high voltage to cause an avalanche breakdown in the cell. The avalanche breakdown produces hot electrons or holes which are then injected into the floating gate of the cell. When data is to be read out from the PROM, the transistor $Q_{29}$ is turned off so that the conduction line I is disconnected from the power supply voltage $V_{PP}$, because, in the reading operation, the potential of the conduction line I is not required to be as high as the power supply voltage $V_{PP}$.

When external light rays are incident through a window (not shown) of a package including the EPROM, electron-hole pairs are generated in the silicon semiconductor substrate of the EPROM. Because the capacitances $C_5$ and $C_6$ in the bootstrap circuit of Fig. 5 used for writing data in the EPROM are constructed by junction capacitances or MOS capacitances, charges stored in these capacitances $C_5$ and $C_6$ leak out due to the generation of the electron-hole pairs within a time of, for example, about 1 milisecond, while several ten miliseconds are required to write data in the PROM. Therefore, these capacitances are required to be repeatedly charged to keep the voltage across the capacitances $C_5$ or $C_6$. During the high potential interval $T_H$ of the oscillation output as illustrated in Fig. 4, these charges $C_5$ and $C_6$ are charged, while, during the low potential interval $T_L$, programming of the EPROM is possible. Thus, as illustrated in Fig. 4, the charging interval corresponding to the interval $T_H$ is shorter than the programmable interval corresponding to the interval $T_L$.

Although three stages of CR time constant circuits are included in the oscillator circuit of this embodiment, the number of stages is not restricted to three, but may be any number as long as the time constant satisfies the required charging time. Also, the number of stages of the inverters are not restricted to six as illustrated, but may be any number, only dependent on the construction of the bootstrap circuit which is to be connected to the oscillator circuit.

From the foregoing description, since the oscillator circuit according to the present invention provides an oscillation frequency having a duty ratio greater than 50%, it will be apparent that the write-in efficiency is greatly improved when the oscillator circuit is adapted to, for example, a bootstrap circuit in an EPROM of a type erasable by means of ultraviolet rays.

## Claims

1. An oscillator circuit for providing an oscillating output having a greater than 50% duty ratio including a delay circuit having its output positively fed back to its input, the delay circuit comprising a plurality of inverters ($INV_1$ to $INV_4$) and capacitive resistive time constant circuits ($CR_1$ to $CR_3$) connected alternately in series, the capacitive resistive time constant circuits ($CR_1$ to $CR_3$) each comprising a depletion type MOS transistor ($Q_4$) and capacitance (C), characterised in that the gates of the MOS transistors ($Q_4$) are connected to their drain or source alternately so that the delay times of all the capacitive resistive time constant circuits ($CR_1$ to $CR_3$) are added together to provide a duty ratio of the oscillator greater than 50%.

2. An oscillator circuit according to claim 1, in which each inverter ($INV_1$ to $INV_6$) comprises a depletion type load MOS transistor ($Q_2$) and an enhancement type MOS transistor ($Q_3$) connected together in series with the gate and the source of the depletion type MOS transistor ($Q_2$) being connected together, the connection between the two transistors ($Q_2$ and $Q_3$) providing an output which is connected to the input of its associated capacitive resistive time constant circuit ($CR_1$ to $CR_3$).

3. An oscillator circuit according to claim 1 or 2, in which the capacitance is formed by the junction capacitance subsisting between the semiconductor substrate and the drain of the depletion type MOS transistor ($Q_4$) in the capacitive resistive time constant circuit ($CR_1$ to $CR_3$).

4. An oscillator circuit according to claims 1 or 2, in which the capacitance is formed by the MOS capacitance of the depletion type MOS transistor ($Q_4$) in the capacitive resistive time constant circuit ($CR_1$ to $CR_3$).

5. An EPROM having a bootstrap circuit including capacitance and an oscillator for controlling the charging of the capacitance during the writing of information into the EPROM, the oscillator circuit including a delay circuit comprising a plurality of inverters ($INV_1$ to $INV_4$) and capacitive resistive time constant circuits ($CR_1$ to $CR_3$) connected alternately in series, the capacitive resistive time constant circuits ($CR_1$ to $CR_3$) each comprising a depletion type MOS transistor ($Q_4$) and capacitance (C), characterised in that the gates of the MOS transistors ($Q_4$), are connected to their drain or source alternately so that the delay times of all the capacitive resistive time constant circuits ($CR_1$ to $CR_3$) are added together to provide a duty ratio of the oscillator greater than 50%.

6. An EPROM according to claim 5, in which each inverter ($INV_1$ to $INV_6$) comprises a depletion type load MOS transistor ($Q_2$) and an enhancement type MOS transistor ($Q_3$) connected together in series with the gate and the source of the depletion type MOS transistor ($Q_2$) being connected together, the connection between the two transistors ($Q_2$ and $Q_3$) providing an output which is connected to the input of its associated capacitive resistive time constant circuit ($CR_1$ to $CR_3$).

## Revendications

1. Circuit oscillateur destiné à produire un signal de sortie oscillant possédant un coefficient d'utilisation supérieur à 50%, comportant un circuit retardateur dont le signal de sortie est renvoyé en réaction positive sur l'entrée, le circuit retardateur comprenant plusieurs inverseurs ($INV_1$ à $INV_4$) et des circuits à constante de temps du type capacitif-résistif (CR₁ à CR₃) alternativement connectés en série, les circuit à constante de temps de type capacitif-résistif (CR₁ à CR₃) comprenant chacun un transistor MOS du type appauvrissement (Q₄) et une capacité (C), caractérisé en ce que les grilles des transistors MOS (Q₄) sont connectées alternativement à leur drain on leur source, de sorte que les retards de tous les circuits à constante de temps de type capacitif-résistif (CR₁ à CR₃) s'ajoutent ensemble pour produire un coefficient d'utilisation de l'oscillateur qui est supérieur à 50%.

2. Circuit oscillateur selon la revendication 1, dans lequel chaque inverseur (INV₁ à INV₆) comprend un transistor MOS de charge du type appauvrissement (Q₂) et un transistor MOS du type enrichissement (Q₃) connectés ensemble en série de façon que la grille et la source du transistor MOS de type appauvrissement (Q₂) soient connectées ensemble, la connexion entre les deux transistors (Q₂ et Q₃) produisant un signal de sortie qui est appliqué à l'entrée de son circuit à constante de temps de type capacitif-résistif associé (CR₁ à CR₃).

3. Circuit oscillateur selon la revendication 1 ou 2, dans lequel la capacité est formée par la capacité de jonction existant entre le substrat semi-conducteur et le drain du transistor MOS de type appauvrissement (Q₄) appartenant au circuit à constante de temps de type capacitif-résistif (CR₁ à CR₃).

4. Circuit oscillateur selon la revendication 1 ou 2, dans lequel la capacité est formée par la capacité MOS du transistor MOS de type appauvrissement (Q₄) appartenant au circuit à constante de temps de type capacitif-résistif (CR₁ à CR₃).

5. Mémoire fixe programmable effaçable possédant un circuit bootstrap qui comporte une capacité et un oscilateur servant à commander la charge de la capacité pendant l'écriture d'information dans la mémoire fixe programmable effaçable, le circuit oscillateur comportant un circuit retardateur qui comprend plusieurs inverseurs (INV₁ à INV₄) et des circuits à constante de temps du type capacitif-résistif (CR₁ à CR₃) connectés alternativement en série, les circuits à constante de temps du type capacitif-résistif (CR₁ à CR₃) comprenant chacun un transistor MOS du type appauvrissement (Q₄) et une capacité (C), caractérisée en ce que les grilles des transistors MOS (Q₄) sont connectées alternativement à leur drain ou leur source, si bien que les retards de tous les circuits à constante de temps du type capacitif-résistif (CR₁ à CR₃) s'ajoutent ensemble pour produire un coefficient d'utilisation de l'oscillateur qui est supérieur à 50%.

6. Mémoire fixe programmable effaçable selon la revendication 5, dans laquelle chaque inverseur (INV₁ à INV₆) comprend un transistor MOS de charge du type appauvrissement (Q₂) et un transistor MOS du type enrichissement (Q₃) connectés ensemble en série de façon que la grille et la source du transistor MOS de type appauvrissement (Q₂) soient connectées ensemble, la connexion entre les deux transistors (Q₂ et Q₃) produisant un signal de sortie qui est appliqué à l'entrée de son circuit à constante de temps du type capacitif-résistif associé (CR₁ à CR₃).

**Patentansprüche**

1. Oszillatorschaltung zur Lieferung eines oszillirenden Ausgangs mit einem Tastverhältnis größer als 50%, mit einer Verzögerungsschaltung, deren Ausgang mit ihrem Eingang mitgekoppelt ist und die eine Anzahl von Invertern (INV₁ bis INV₄) und kapazitivohmische Zeitkonstantenschaltungen (CR₁ bis CR₃) umfaßt, welche alternativ in Serie geschaltet sind, wobei die kapazitiv-ohmischen Zeitkonstantenschaltungen (CR₁ bis CR₃) jeweils einen MOS-Transistor (Q₄) vom Verarmungstyp und eine Kapazität (C) umfassen, dadurch gekennzeichnet, daß die Gateelektroden der MOS-Transistoren (Q₄) abwechselnd mit ihrer Drain- bzw. mit ihrer Source-elektrode verbunden sind, so daß die Verzögerungszeiten aller kapazitiv-ohmischen Zeitkonstantenschaltungen (CR₁ bis CR₃) zusammenaddiert werden, um ein Tastverhältnis des Oszillators von über 50% zu liefern.

2. Oszillatorschaltung nach Anspruch 1, bei welcher jeder Inverter (INV₁ bis INV₆) einen MOS-Lasttransistor (Q₂) vom Verarmungstyp und einen MOS-Transistor (Q₃) vom Anreicherungstyp, welcher in Reihe mit der Gateelektrode und der Sourceelektrode des MOS-Transistors (Q₂) vom Verarmungstyp geschaltet ist, umfaßt, welche miteinander verbunden sind, wobei die Verbindung zwischen den beiden Transistoren (Q₂ und Q₃) einen Ausgang bildet, welcher mit dem Eingang seiner zugeordneten kapazitiv-ohmischen Zeitkonstantenschaltung (CR₁ bis CR₃) verbunden ist.

3. Oszillatorschaltung nach Anspruch 1 oder 2, bei welcher die Kapazität von der Sperrschichtskapazität gebildet ist, welche zwischen dem Halbleitersubstrat und der Drainelektrode des MOS-Transistors vom Verarmungstyp (Q₄) in der kapazitiv-ohmischen Zeitkonstantenschaltung (CR₁ bis CR₃) existiert.

4. Oszillatorschaltung nach Anspruch 1 oder 2, bei welcher die Kapazität der kapazitivohmischen Zeitkonstantenschaltung (CR₁ bis CR₃) von der MOS-Kapazität des MOS-Transistors (Q₄) vom Verarmungstyp gebildet ist.

5. EPROM mit einer Bootstrapschaltung, mit einem Kondensator und mit einem Oszillator, welcher zur Steuerung der Ladung des Kondensators während des Einschreibens von Information in das EPROM dient und welcher eine Verzögerungsschaltung umfaßt, deren Ausgang mit ihrem Eingang mitgekoppelt ist und die eine Anzahl von Invertern (JNV₁ bis INV₄) und kapazitiv-ohmische Zeitkonstantenschaltungen (CR₁ bis CR₃) umfaßt, welche alternativ in Serie geschaltet sind, wobei die kapazitiv-ohmischen

Zeitkonstantenschaltungen (CR$_1$ bis CR$_3$) jeweils einen MOS-Transistor (Q$_4$) vom Verarmungstyp und eine Kapazität (C) umfassen, dadurch gekennzeichnet, daß die Gateelektroden der MOS-Transistoren (Q$_4$) abwechselnd mit ihrer Drain- bzw. mit ihrer Sourceelektrode verbunden sind, so daß die Verzögerungszeiten aller kapazitiv-ohmischen Zeitkonstantenschaltungen (CR$_1$ bis CR$_3$) zusammenaddiert werden, um ein Tastverhältnis des Oszillators von über 50% zu liefern.

6. EPROM nach Anspruch 5, bei welcher jeder Inverter (INV$_1$ bis INV$_6$) einen MOS-Lasttransistor (Q$_2$) vom Verarmungstyp und einen MOS-Transistor (Q$_3$) vom Anreicherungstyp, welcher in Reihe mit der Gateelektrode und der Sourceelektrode des MOS-Transistors (Q$_2$) vom Verarmungstyp geschaltet ist, umfaßt, welche miteinander verbunden sind, wobei die Verbindung zwischen den beiden Transistoren (Q$_2$ und Q$_3$) einen Ausgang bildet, welcher mit dem Eingang seiner zugeordneten kapazitivohmischen Zeitkonstantenschaltung (CR$_1$ bis CR$_3$) verbunden ist.

## Fig. 1

## Fig. 2

## Fig. 3

# Fig. 4

# Fig. 5